Europäisches Patentamt

**European Patent Office**

Office européen des brevets

(19)

(11) Veröffentlichungsnummer : **0 072 967**
**B1**

(12) **EUROPÄISCHE PATENTSCHRIFT**

(45) Veröffentlichungstag der Patentschrift :
**03.12.86**

(21) Anmeldenummer : **82107239.4**

(22) Anmeldetag : **10.08.82**

(51) Int. Cl.⁴ : **H 01 L 21/82**, H 01 L 21/28,
H 01 L 21/265

(54) **Verfahren zum Herstellen von hochintegrierten komplementären MOS-Feldeffekttransistorschaltungen in Silizium-gate-Technologie.**

(30) Priorität : **25.08.81 DE 3133468**

(43) Veröffentlichungstag der Anmeldung :
**02.03.83 Patentblatt 83/09**

(45) Bekanntmachung des Hinweises auf die Patenterteilung : **03.12.86 Patentblatt 86/49**

(84) Benannte Vertragsstaaten :
**AT DE FR GB IT SE**

(56) Entgegenhaltungen :
**DE-A- 2 700 873**
**DE-A- 2 933 849**
**US-A- 4 084 311**
**US-A- 4 167 018**

(73) Patentinhaber : **Siemens Aktiengesellschaft Berlin
und München
Wittelsbacherplatz 2
D-8000 München 2 (DE)**

(72) Erfinder : **Schwabe, Ulrich, Dr.
Grünwalderstrasse 40
D-8000 München 90 (DE)**
Erfinder : **Jacobs, Erwin, Dr.
Stieglitzweg 9b
D-8011 Vaterstetten (DE)**
Erfinder : **Schelbe, Adolf, Dr.
Finkenstrasse 9a
D-8012 Ottobrunn (DE)**

EP 0 072 967 B1

Jouve, 18, rue St-Denis, 75001 Paris, France

**Beschreibung**

Die vorliegende Patentanmeldung betrifft ein Verfahren zum Herstellen von hochintegrierten komplementären MOS-Feldeffekttransistorschaltungen in Siliziumgate-Technologie, insbesondere mit in der Schaltung enthaltenen Schaltkapazitäten aus Doppelpolysiliziumstrukturen, bei dem die Verfahrensschritte zur Definition der Wannen für die Aufnahme der n-bzw. p-Kanaltransistoren, die Feld- und Kanalimplantationen für die aktiven MOS-Bereiche der Schaltung, sowie die Erzeugung der Feldoixdbereiche, des Gateoxids und die Abscheidung und Strukturierung der Polysilizium-1-Ebene zur Bildung der Gatebereiche und der Kapazitätsstrukturen in bekannter Weise vorgenommen wird.

Die Aufgabe, die der vorliegenden Erfindung zugrundeliegt, besteht in der Durchführung eines CMOS-Prozesses, bei dem möglichst wenige Prozeßschritte zur Herstellung der gewünschten Schaltungen erforderlich sind, bei dem aber trotzdem gewährleistet wird, daß die Funktionsweise der Bauelemente der Schaltung dadurch nicht beeinträchtigt wird. Außerdem soll die Prozeßfolge auch erlauben, daß Schaltkapazitätsstrukturen in Silizium-2-Gate-Technologie während des Verfahrens zur Herstellung der aus n- und p-Kanal-Transistoren bestehenden Schaltung ohne großen Aufwand, das heißt, ohne zusätzliche Maskierungsschritte, mit erzeugt werden können.

Bei den aus dem Stand der Technik bekannten Prozessen zur Herstellung von hochintegrierten komplementären MOS-Feldeffekttransistorschaltungen (CMOS-Schaltungen) werden zur Source/Drain-Implantation der n-Kanal- und der p-Kanal-Transistoren verschiedene Technologien, die sehr aufwendig sind, verwendet.

So ist aus einem Aufsatz von T. Ohzone et al, « Silicon-Gate n-Well CMOS Process by Full Ion-Implantation Technology » aus dem IEEE Transact. Electr. Devices ED-27 (1980), Seiten 1789-1795 bekannt, für die $n^+$-Implantation der n-Kanal-Transistoren und für die $p^+$-Implantation der p-Kanal-Transistoren der Schaltung getrennte, also zwei Masken, zu verwenden. Dies hat den Nachteil, daß der an und für sich schon im Bezug auf Ausbeute kritische CMOS-Fertigungsprozeß durch eine zusätzliche Maske noch belastet wird.

Ein anderes Verfahren, welches nur mit einer Maske bei den Source/Drain-Implantationen arbeitet und dafür durch zwei verschiedene Ionenimplantationen das Diffusionsgebiet des einen Leitfähigkeitstyps mit einer höher dotierten Ionenimplantation des anderen Leitfähigkeitstyps überkompensiert, ist aus einem Aufsatz von L. C. Parillo et al, « Twin Tub CMOS — A Technology for VLSI-Circuits » aus dem Techn. Dig. IEDM 1980, 29.1., Seiten 752-755 zu entnehmen. Der Nachteil dieses Verfahrens ist, daß keine flachen Source/Drain-Gebiete (vertikale Eindringtiefe $x_j < 0,5 \ \mu m$) erzielbar sind.

Bei bekannten Verfahren ist es außerdem erforderlich, daß die Herstellung von Kapazitätsstrukturen in einem Doppelpolysiliziumgate-CMOS-Prozeß eine zusätzliche Maske zur Strukturierung des Dielektrikums erfordert, was wiederum eine Verringerung der Ausbeute des Prozesses zur Folge hat.

Um alle diese Nachteile zu vermeiden, ist es ein wesentlicher Bestandteil der Erfindung, für beide Source/Drain-Implantationen nur eine einzige Maske zu verwenden und auch zu vermeiden, daß eine Doppelimplantation in ein Diffusionsgebiet durchgeführt werden muß.

Dies wird durch ein Verfahren der eingangs genannten Art erreicht, welches erfindungsgemäß durch den Ablauf folgender Verfahrensschritte gekennzeichnet ist

a) thermische Aufoxidation der gesamten Oberfläche in dem Maße, daß die Oxidschichtdicke $d_4$ über den Polysiliziumstrukturen der gewünschten Dicke der Isolationsschicht für die. Kapazitätsstrukturen entspricht, wobei zugleich die Streuoxidschichtdicke $d_3$ über den Source/Drain-Bereichen bestimmt wird, die die später erfolgenden Ionenimplantationen zur Erzeugung der Source-Drain-Bereiche der p-Kanal und n-Kanal Transistoren nicht maskiert,

b) Abscheidung einer ganzflächigen, die Source-Drain-Bereiche der p-Kanal-Transistoren maskierenden Siliziumnitridschicht in einer der Implantationsenergie der nachfolgenden Source-Drain-Implantation angepaßten Schichtdicke,

c) Strukturierung der Siliziumnitridschicht in der Weise, daß die Bereiche der p-Kanal-Transistoren, sowie die für die Kapazitäten vorgesehenen Polysiliziumstrukturen von der Siliziumnitridschicht bedeckt bleiben,

d) Durchführung der Implantation zur Erzeugung der Source-Drain-Bereiche der n-Kanal-Transistoren, die bei der nachfolgenden Oxidation eingetrieben werden,

e) thermische Aufoxidation der Oberfläche in dem Maße, daß die Oxidschichtdicke $d_6$ über den Source-Drain-Bereich der n-Kanal-Transistoren als Maskierungsschicht ausreichend ist,

f) Entfernen der Nitridschichtstrukturen,

g) Durchführung einer ganzflächigen Implantation zur Erzeugung der Source-Drain-Bereiche der p-Kanal-Transistoren,

h) Abscheidung und Strukturierung der Polysilizium-2-Ebene für die Kapazitätsstrukturen und

i) Erzeugung der Isolationsschicht, der Kontaktlochbereiche und der Metall-Leiterbahnstrukturebene in bekannter Weise.

Mit der als Verfahrensschritt a) bezeichneten Oxidation wird zum einen die über dem Substrat freiliegende Oxidschicht zu einem Streuoxid aufoxidiert, zum anderen wächst das für die Isolationsschicht erforderliche Kapazitätsoxid auf den Polysiliziumbereichen in der gewünschten Dicke auf, welches für beide Source/Drain-Implantationen (n-Kanal- und p-Kanal-Transistoren) maskierend wirkt und an den Polysilizium-Kanten einen « pull-back »-Effekt zur Folge hat. Mit dem « pull-back » wird die Kante der Implantation vom Polysilizium zurückgezogen, wobei jedoch die selbstjustierende Eigenschaft des Polysilizium für die Source/Drain-Implantation erhalten bleibt. Bei der nachfolgenden lateralen Ausdiffusion der Source/Drain-Bereiche ergibt sich eine definiert kleine Unterdiffusion der Gatebereiche und somit eine wesentliche Verringerung der Miller-Kapazitäten (parasitäre Kapazitäten von Gate-Source- und Gate-Drain-Bereichen). Daraus resultiert eine Erhöhung der Schaltgeschwindigkeit. Die Oxidationsdauer bestimmende Größe ist deshalb die erwünschte Dicke des Kapazitätsoxids ($d_4 = d_{cox}$).

Für den Prozeß neuartig und entscheidens ist es ferner, daß diese Oxidation zur Bildung der Isolationsschicht von Kapazitätsstrukturen (switched capacitors), die in Filterbausteinen für TELE-COM-Anwendungen die Widerstände des RC-Netzwerkes bilden, verwendet werden kann.

Es ergibt sich damit die Einsparung einer weiteren Maske, die bei bisher bekannten Prozeßfolgen erforderlich ist.

Es ist aber auch möglich, die Prozeßführung so zu gestalten, daß komplementäre Feldeffekttransistorschaltungen ohne zusätzliche Schaltkapazitäten (switched capacitors) hergestellt werden können. Dafür muß dann nur der Verfahrensschritt h) entfallen ; die Einstellung der Oxidschichtdicke nach Verfahrensschritt a) erfolgt nach der Oxidschichtdicke $d_3$ und die Strukturierung der Siliziumnitridschicht nach Verfahrensschritt c) erfolgt so, daß nur die Bereiche der p-Kanal-Transistoren von der Siliziumnitridschicht bedeckt bleiben.

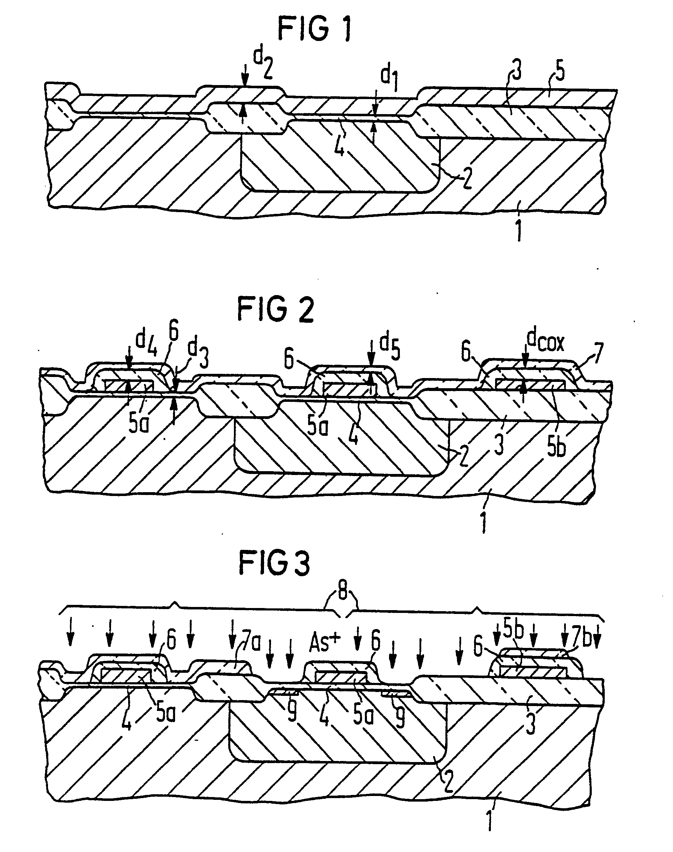

Weitere Einzelheiten und Vorteile des erfindungsgemäßen Verfahrens ergeben sich aus den Unteransprüchen sowie aus der Beschreibung eines Ausführungsbeispiels anhand der Figuren 1 bis 6, in denen die durch die erfindungswesentlichen Verfahrensschritte erzielten Strukturen im Schnittbild dargestellt sind. In allen Figuren gelten für gleiche Teile gleiche Bezugszeichen. Als Ausführungsbeispiel wird der Prozeßablauf für die Source/Drain-Implantation der p- und n-Kanal-Transistoren und die Herstellung von Kapazitäten innerhalb eines CMOS-Prozesses zur Herstellung von integrierten Halbleiterschaltungen in VLSI-Technologie beschrieben.

Figur 1

Bis zum Prozeßschritt der Strukturierung der Polysilizium-1-Ebene (5) sind die herkömmlichen Verfahren der CMOS-Prozeßtechnologie anwendbar. Der besseren Übersicht wegen wird deshalb auf die Einzeichnung der durch die bekannten Prozeßschritte erhaltenen Strukturen mit Ausnahme der im n-dotierten Siliziumsubstrat 1 für die n-Kanal-Transistoren erforderlichen p-Wanne 2, des Feldoxids 3, und des Gateoxids 4 verzichtet. Figur 1 zeigt die Anordnung, in der auf das Gateoxid 4 mit einer Schichtdicke $d_1$ und beispielsweise 40 nm eine Polysiliziumschicht 5 mit einer Schichtdicke $d_2$ von 500 nm abgeschieden worden ist.

Figur 2

Nach der Strukturierung der Polysilizium-1-Ebene 5 zur Bildung der Gatebereiche 5a und der Kapazitätsstrukturen 5b (erste oder untere Elektrode) wird die gesamte Oberfläche thermisch aufoxidiert, wobei zum einen die freiliegende 40 nm dicke Oxidschicht $d_1$ zu einem ca. 50 nm dicken Streuoxid $d_3$ aufoxidiert wird, zum anderen wächst ein ca. 100 nm (= $d_4$) dickes Oxid 6 auf dem Polysiliziumbereichen 5a und 5b auf, welches für beide Source-Drain-Implantationen (n- und p-Kanal-Transistoren) maskierend wirkt und an den Polysilizium-Flanken (5a) einen « pull-back »-Effekt zur Folge hat. Oxidationsdauer bestimmende Größe ist deshalb die erwünschte Dicke $d_4$ bzw. $d_{cox}$ der auf dem Polysiliziumbereichen 5a und 5b befindlichen Oxidschicht 6. Dieses Oxid (6) und auch die durch das Streuoxid verstärkte Oxidschicht (4) bildet die Unterlage für die nun aufzubringende Siliziumnitridschicht 7, deren Dicke $d_5$ so gewählt wird, daß sie die Maskierung gegen die Arsen-Implantation zur Erzeugung der n-Kanal-Transistoren in der p-Wanne 2 gewährleistet. Im Ausführungsbeispiel ist $d_5 = 100$ nm.

Figur 3

Die Siliziumnitridschicht 7a (strukturiert) wird als Maske für die nun folgende Arsen[+]-Implantation 8 verwendet, wobei für Dosis und Energie Werte zwischen $3 \cdot 10^{15}$ und $1 \cdot 10^{16}$ cm$^{-2}$ bzw. 80 und 100 keV eingestellt werden. Es entstehen die Source-Drain-Bereiche 9 der n-Kanal-Transistoren, die bei der nachfolgenden Oxidation eingetrieben werden.

Figur 4

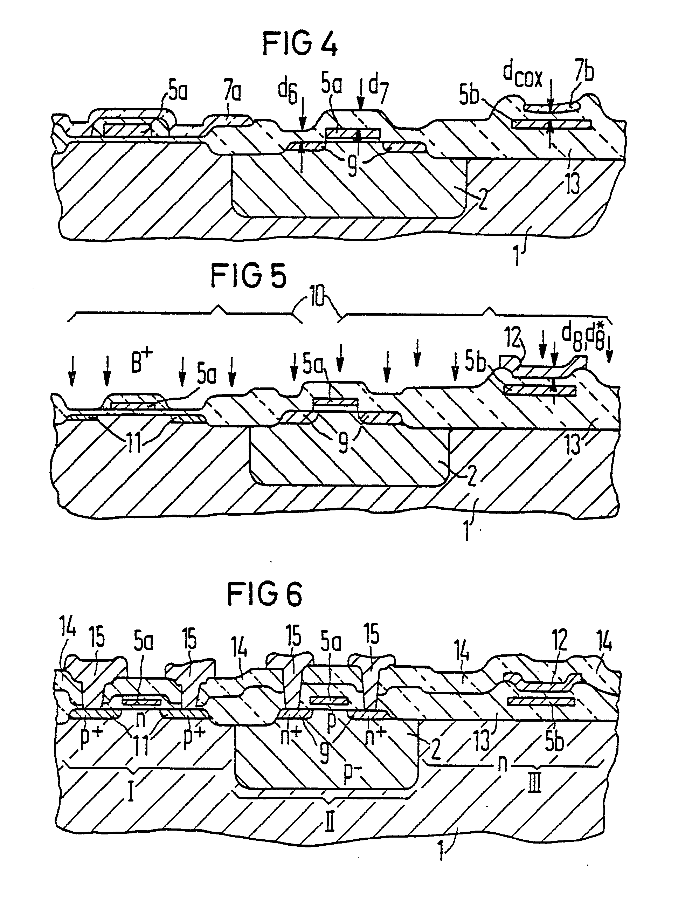

Bei der, nach der Arsen-Implantation 8 erfolgten thermischen Oxidation werden die Oxide im n[+]-Bereich (9) auf Dicken $d_6$ aufoxidiert, die eine ausreichende Maskierung bei der noch folgenden Bor-Implantation zur Erzeugung der p-Kanal-Transistoren gewährleisten. Im Ausführungsbeispiel beträgt die Dicke $d_6$ 220 nm (vor der Oxidation : $d_3$) und die Dicke $d_7$ über dem Gate der n-Kanal-Transistoren 400 nm (vor der Oxidation : $d_4$). Diese Oxidation ist praktisch ein zweiter LOCOS-Schritt (wegen der noch vorhandenen Nitridschicht 7a). Das Kapazitätsoxid $d_{cox}$ (= $d_4$) bleibt wegen der Nitridmaskierung 7b unbeeinflußt. Der Einfachheit halber wird das auf dem gesamten Substrat befindliche Oxid in der Figur 4 und den nun folgenden Figuren mit dem Bezugszeichen 13 versehen.

Figur 5

Nach Entfernung der Nitridstrukturen 7a und 7b erfolgt nun die Bor-Implantation zur Erzeugung der p-Kanal-Transistoren ganzflächig ohne Maske. Dabei werden Dosis und Energie zwischen $2 \cdot 10^{15}$ und $4 \cdot 10^{15}$ cm$^{-2}$ bzw. 20 und 25 keV eingestellt. Nach dem Eintreiben der implantierten Dotierstoffatome entstehen die Source/Drain-Bereiche 11 der p-Kanal-Transistoren.

Bei einem Doppel-Polysilizium-2-Prozeß erfolgt nun die Abscheidung einer Polysilizium-2-Schicht in einer Schichtdicke $d_8$ von 500 nm oder beispielsweise einer Tantalsilizid-Schicht (TaSi$_2$) in einer Schichtdicke $d_8$* von 200 bis 300 nm. Polysilizium-2- oder Silizidschicht bilden nach ihrer Strukturierung zum einen die obere Elektrode 12 der Kapazitätsstrukturen (weitere Elektrode : 5b), zum anderen kann sie als zweite Verdrahtungsebene (in der Figur nicht dargestellt) verwendet werden.

Figur 6

Alle weiteren Prozesse, wie Aufbringen des Isolationsoxids 14, Einbringen der Kontaktlöcher, Herstellung der metallischen Leiterbahnebene 15 (z. B. Aluminium/Silizium oder Aluminium/Silizium/Titan) und Passivierung der Schaltung erfolgen in bekannter Weise.

In Figur 6 ist mit I der Bereich der p-Kanal-Transistoren, mit II der Bereich der n-Kanal-Transistoren und mit III der Kapazitätsbereich der Schaltung bezeichnet.

**Patentansprüche**

1. Verfahren zum Herstellen von hochintegrierten komplementären MOS-Feldeffekttransistorschaltungen in Siliziumgate-Technologie, insbesondere mit in der Schaltung enthaltenen Schaltkapazitäten aus Doppelpolysiliziumstrukturen, bei dem die Verfahrensschritte zur Definition der Wannen für die Aufnahme der n- bzw. p-Kanaltransistoren, die Feld- und Kanalimplantationen für die aktiven MOS-Bereiche der Schaltung, sowie die Erzeugung der Feldoxidbereiche, des Gateoxids und die Abscheidung und Strukturierung der Polysilizium-1-Ebene zur Bildung der Gatebereiche und der Kapazitätsstrukturen in bekannter Weise vorgenommen wird, gekennzeichnet durch den Ablauf der nun folgenden Verfahrensschritte :

a) thermische Aufoxidation der gesamten Oberfläche in dem Maße, daß die Oxidschichtdicke $d_4$ über den Polysiliziumstrukturen (5a, 5b) der gewünschten Dicke der Isolationsschicht für die Kapazitätsstrukturen entspricht, ($d_4 = d_{cox}$) wobei zugleich die Streuoxidschichtdicke $d_3$ über den Source-Drain-Bereichen (9, 11) bestimmt wird, die die später erfolgenden Ionenimplantationen (8, 10) zur Erzeugung der Source-Drain-Bereiche der p-Kanal und n-Kanal Transistoren nicht maskiert,

b) Abscheidung einer ganzflächigen, die Source-Drain-Bereiche (11) der p-Kanal-Transistoren maskierenden Siliziumnitridschicht (7) in einer, der Implantations-energie der nachfolgenden Source-Drain-Implantation (8) angepaßten Schichtdicke ($d_5$),

c) Strukturierung der Siliziumnitridschicht (7a, 7b) in der Weise, daß die Bereiche der p-Kanal-Transistoren (11), sowie die für die Kapazitäten vorgesehenen Polysiliziumstrukturen (5b) von der Siliziumnitridschicht bedeckt bleiben,

d) Durchführung der Implantation (8) zur Erzeugung der Source-Drain-Bereiche (9) der n-Kanal-Transistoren, die bei der nachfolgenden Oxidation eingetrieben werden,

e) thermische Aufoxidation der Oberfläche in dem Maße, daß die Oxidschichtdicke $d_6$ über den Source-Drain-Bereichen (9) der n-Kanaltransistoren für die nachfolgende Implantation (10) zur Erzeugung der Source-Drain-Bereiche (11) der p-Kanaltransistoren als Maskierungsschicht ausreichend ist,

f) Entfernen der Nitridschichtstrukturen (7a, 7b),

g) Durchführung einer ganzflächigen Implantation (10) zur Erzeugung der Source-Drain-Bereiche (11) der p-Kanal-Transistoren,

h) Abscheidung und Strukturierung der Polysilizium-2-Ebene (12) für die Kapazitätsstrukturen und

i) Erzeugung der Isolationsschicht (14), der Kontaktlochbereiche und der Metall-Leiterbahnstrukturebene (15) in bekannter Weise (Figur 4, 6).

2. Verfahren nach Anspruch 1, dadurch gekennzeichnet, daß zur Herstellung von komplementären Feldeffekttransistorschaltungen ohne zusätzliche Schaltkapazitätsstrukturen

A) der Verfahrensschritt h) entfällt,

B) die Einstellung der Oxidschichtdicke nach Verfahrensschritt a) nach der Oxidschichtdicke $d_3$ erfolgt und

C) die Strukturierung der Siliziumnitridschicht (7a) nach Verfahrensschritt c) so erfolgt, daß nur die Bereiche (11) der p-Kanaltransistoren von der Siliziumnitridschicht bedeckt bleiben.

3. Verfahren nach Anspruch 1, dadurch gekennzeichnet, daß anstelle der Polysilizium-2-Ebene (12) eine aus Siliziden hochschmelzender Metalle, vorzugsweise TaSi$_2$, bestehende Ebene verwendet wird.

4. Verfahren nach mindestens einem der Ansprüche 1 bis 3, dadurch gekennzeichnet, daß die Oxidschichtdicke $d_4$ über die Oxidationszeit auf einen Wert im Bereich von 50-200 nm eingestellt wird.

5. Verfahren nach mindestens einem der Ansprüche 1 bis 4, dadurch gekennzeichnet, daß die Dicke $d_5$ der Siliziumnitridschicht (7) auf einen Wert im Bereich von 50-150 nm eingestellt wird.

6. Verfahren nach mindestens einem der Ansprüche 1 bis 5, dadurch gekennzeichnet, daß die Dosis und Energie bei der Source/Drain-Implantation (8) der n-Kanal-Transistoren (9) mit Arsen auf $1 \cdot 10^{15}$ bis $1 \cdot 10^{16}$ cm$^{-2}$ bzw. 80 bis 100 keV eingestellt wird.

7. Verfahren nach mindestens einem der Ansprüche 1 bis 6, dadurch gekennzeichnet, daß die Oxidschichtdicke $d_6$ über die Oxidationszeit auf einem Wert im Bereich von 100 bis 300 nm eingestellt wird.

8. Verfahren nach mindestens einem der Ansprüche 1 bis 7, dadurch gekennzeichnet, daß die Dosis und Energie bei der Source/Drain-Implantation (10) der p-Kanal-Transistoren (11) mit Bor auf $1 \cdot 10^{15}$ bis $1 \cdot 10^{16}$ cm$^{-2}$ bzw. 20 bis 25 keV eingestellt wird.

9. Verfahren nach mindestens einem der Ansprüche 1 bis 8, dadurch gekennzeichnet, daß die Schichtdicke der Polysilizium-2-Ebene (12) $d_8$ auf 200 bis 500 nm bzw. die Schichtdicke der Silizidebene $d_8^*$ auf 200 bis 300 nm eingestellt wird.

**Claims**

1. A process for the production of highly integrated, complementary MOS-field effect transistor circuits using silicon-gate technology, in particular having switching capacitors included in the circuit and consisting of double polysilicon structures, in which the process steps for the definition of the troughs to accommodate the n- and p-channel transistors, the field- and channel implantations for the active MOS-regions of the circuit, and the production of the field oxide regions and of the gate oxide, and the deposition and structuring of the polysilicon-1-level to form the gate regions and the capacitor structures are carried out in known manner, characterised by the sequence of the following process steps :

a) thermal oxidation of the entire surface to the extent that the oxide layer thickness $d_4$ above the polysilicon structures (5a, 5b) corresponds to the desired thickness of the insulating layer required for the capacitor structures $(d_4 = d_{cox})$, whereby at the same time the stray oxide layer thickness $d_3$ above the source-drain-zones (9, 11) is set so that it does not mask the later ion implantation steps (8, 10) for the production of the source-drain-zones of the p-channel and m-channel transistors,

b) deposition on to the entire surface of a silicon nitride layer (7), which masks the source-drain-zones (11) of the p-channel transitors, with a layer thickness $(d_5)$ which is adapted to the implantation energy of the subsequent source-drain-implantation (8),

c) structuring of the silicon nitride layer (7a, 7b) in such a way that the zones of the p-channel transistors (11) and the polysilicon structures (5b), which are provided for the capacitors, remain covered by the silicon nitride layer,

d) carrying out of the implantation step (8) to produce the source-drain-zones (9) of the n-channel transistors which are driven inwards during a subsequent oxidation process,

e) thermal oxidation of the surface to the extent that the oxide layer thickness $d_6$ above the source-drain-zones (9) of the n-channel transistors is adequate as a masking layer during the subsequent implantation step (10) to produce the source-drain-zones (11) of the p-channel transistors,

f) removal of the nitride layer structures (7a, 7b),

g) carrying out of an implantation step (10) over the entire surface in order to produce the source-drain-zones (11) of the p-channel transistors,

h) deposition of and structuring of the polysilicon-2-level (12) for the capacitor structures, and

i) production of the insulating layer (14), the contact hole regions and the metal-conductor path structure level (15) in known manner (Fig. 4, 6).

2. A process as claimed in Claim 1, characterised in that, in order to produce complementary field effect transistor circuits without additional switched capacitor structures,

A) process step h) is dispensed with,

B) the adjustment of the oxide layer thickness in accordance with process step a) takes place in accordance with the oxide layer thickness $d_3$ and

C) the structuring of the silicon nitride layer (7a) in accordance with process step c) takes place in such a way that only the zones (11) of the p-channel transistors remain covered by the silicon nitride layer.

3. A process as claimed in Claim 1, characterised in that a level consisting of silicides of metal having a high melting point, preferably $TaSi_2$, is used in place of the polysilicon-2-level (12).

4. A process as claimed in at least one of Claims 1 to 3, characterised in that the oxide layer thickness $d_4$ is set by the oxidation time at a value within the range of 50-200 nm.

5. A process as claimed in at least one of Claims 1 to 4, characterised in that the thickness $d_5$ of the silicon nitride layer (7) is set at a value within the range of 50-150 nm.

6. A process as claimed in at least one of Claims 1 to 5, characterised in that the dosage and energy of the source-drain implantation (8) of the n-channel transistors (9) with arsenic are set at $1 \cdot 10^{15}$ to $1 \cdot 10^{16}$ cm$^{-2}$ and 80 to 100 keV respectively.

7. A process as claimed in at least one of Claims 1 to 6, characterised in that the oxide layer thickness $d_6$ is set by the oxidation time at a value within the range of 100 to 300 nm.

8. A process as claimed in at least one of Claims 1 to 7, characterised in that the dosage and energy of the source/drain implantation (10) of the p-channel transistors (11) with boron are set at $1 \cdot 10^{15}$ to $1 \cdot 10^{16}$ cm$^{-2}$ and 20 to 25 keV respectively.

9. A process as claimed in at least one of Claims 1 to 8, characterised in that the layer thickness of the polysilicon-2-level (12) $d_8$ is set at 200 to 500 nm and the layer thickness of the silicide level $d_8^*$ is set at 200 to 300 nm.

**Revendications**

1. Procédé pour fabriquer des circuits à transistors à effet de champ MOS complémentaires à haute densité d'intégration selon la technologie des grilles en silicium et comportant notamment des capacités de commutation contenues dans le circuit et constituées par des structures en polysilicium doubles, et selon lequel les phases opératoires servant à définir les puits servant à loger les transistors à canal p ou n, les implantations de champs et de canaux pour les zones MOS actives du circuit ainsi que la réalisation des zones d'oxyde de champ, de l'oxyde de grille et le dépôt et la structuration du plan 1 du polysilicium servant à former les régions de grille et les structures capacitives sont réalisées de façon connue, caractérisé par l'exécution des phases opératoires suivantes :

a) oxydation thermique de l'ensemble de la surface au point que l'épaisseur $d_4$ de la couche d'oxyde au-dessus des structures de polysilicium (5a, 5b) correspond à l'épaisseur désirée de la couche isolante pour les structures des capacités ($d_4 = d_{cox}$), et que simultanément se trouve déterminée l'épaisseur $d_3$ de la couche d'oxyde diffusée au-dessus des régions de source et de drain (11), qui ne masque pas les implantations ioniques (8, 10) mises en œuvre ultérieurement pour la réalisation des régions de source et de drain des transistors à canal p et à canal n,

b) dépôt d'une couche de nitrure de silicium (7) s'étendant sur l'ensemble de la surface qui masque les régions de source et de drain (11) des transistors à canal p, et possédant une épaisseur de couche ($d_5$) adaptée à l'énergie mise en œuvre lors de l'implantation ultérieure (8) de la source et du drain,

c) structuration de la couche de nitrure de silicium (7a, 7b) de telle sorte que les régions des transistors à canal n (11) ainsi que les structures en polysilicium (5b) prévues pour les capacités restent recouvertes par la couche de nitrure de silicium,

d) mise en œuvre de l'implantation (8) pour l'obtention des régions de source et de drain (9) des transistors à canal n, qui sont produits lors de l'oxydation ultérieure,

e) oxydation thermique de la surface à un degré tel que l'épaisseur $d_6$ de la couche d'oxyde au-dessus des régions de source et de drain (9) des transistors à canal n est suffisante en tant que couche de masquage pour l'implantation ultérieure (10) servant à former les régions de source et de drain (11) des transistors à canal p,

f) suppression des structures (7a, 7b) de la couche de nitrure,

g) mise en œuvre d'une implantation (10) réalisée sur toute la surface et servant à produire la région de source et de drain (11) des transistors à canal p,

h) dépôt et structuration du plan 2 du polysilicium (12) pour les structures des capacités, et

i) fabrication de la couche isolante (4), des régions des trous de contacts et du plan (15) des structures des voies conductrices métalliques, de façon connue (figures 4, 6).

2. Procédé selon la revendication 1, caractérisé en ce que pour fabriquer des circuits à transistors à effet de champ complémentaires sans structures supplémentaires de capacités de commutation,

A) la phase opératoire h) est supprimée,

B) le réglage de l'épaisseur de la couche d'oxyde conformément à la phase opératoire a) est réalisé en fonction à l'épaisseur $d_3$ de la couche d'oxyde, et

C) la structuration de la couche de nitrure de silicium (7a) est réalisée conformément à la phase opératoire c) de sorte que seules les régions (11) des transistors à canal p restent recouvertes par la couche de nitrure de silicium.

3. Procédé suivant la revendication 1, caractérisé par le fait qu'à la place du plan 2 du polysilicium (12), on utilise un plan constitué par des siliciures de métaux à point de fusion élevé, de préférence du $TaSi_2$.

4. Procédé suivant au moins l'une des revendications 1 à 3, caractérisé par le fait qu'on règle l'épaisseur $d_4$ de la couche d'oxyde, obtenue durant le temps de l'oxydation, à une valeur située dans la gamme comprise entre 50 et 200 nm.

5. Procédé suivant au moins l'une des revendications 1 à 4, caractérisé par le fait que l'épaisseur $d_5$ de la couche de nitrure de silicium (7) est réglée à une valeur située dans la gamme comprise entre 50 et 150 nm.

6. Procédé suivant au moins l'une des revendications 1 à 5, caractérisé par le fait qu'on règle la dose et l'énergie mise en jeu lors de l'implantation (8) de la source/du drain des transistors à canal n (9) avec de l'arsenic, respectivement à une valeur comprise entre $1 \cdot 10^{15}$ et $1 \cdot 10^{16}$ cm$^{-2}$ et à une valeur comprise entre 80 et 100 keV.

7. Procédé suivant au moins l'une des revendications 1 à 6, caractérisé par le fait qu'on règle l'épaisseur $d_6$ de la couche d'oxyde obtenue durant le temps de l'oxydation à une valeur située dans la gamme comprise entre 100 et 300 nm.

8. Procédé suivant au moins l'une des revendications 1 à 7, caractérisé par le fait qu'on règle la dose et l'énergie dans le cas d'une implantation (10) de la source/du drain des transistors à canal p (11) avec du bore, respectivement à une valeur comprise entre $1 \times 10^{15}$ et $1 \times 10^{16}$ cm$^{-2}$ et une valeur comprise entre 20 et 25 keV.

9. Procédé suivant au moins l'une des revendications 1 à 8, caractérisé par le fait qu'on règle l'épaisseur de la couche $d_8$ du plan 2 du polysilicium (12) à une valeur comprise entre 200 et 500 nm et qu'on règle l'épaisseur $d_8{}^*$ de la couche du plan de siliciure à une valeur comprise entre 200 et 300 nm.

FIG 1

FIG 2

FIG 3

## FIG 4

$d_{COX}$

$5a$    $7a$    $d_6$   $5a$   $d_7$     $5b$     $7b$

$9$     $2$    $13$

$1$

## FIG 5

$10$

$B^+$   $5a$     $5a$     $5b$   $12$   $d_8, d_8^*$

$11$     $9$     $13$

$2$

$1$

## FIG 6

$14$   $15$   $5a$   $15$    $14$   $15$   $5a$   $15$     $14$    $12$   $14$

$p+$   $n$    $p+$     $n+$   $p$   $n+$    $2$   $13$    $5b$

$11$      $9$    $p-$     $n$

$I$       $II$      $III$

$1$